# EUROPÄISCHE PATENTSCHRIFT

(11) **EP 4 010 286 B1**
(45) Veröffentlichungstag und Bekanntmachung des Hinweises auf die Patenterteilung: **31.05.2023**
(21) Anmeldenummer: 20749877.5
(22) Anmeldetag: 30.07.2020
(51) Int. Cl.: C01B 21/068, C01B 32/963, C01B 32/984, C30B 29/36, H01L 29/16

(54) **VERFAHREN UND VORRICHTUNG ZUR ERZEUGUNG SILIZIUMHALTIGER MATERIALIEN**
METHOD AND APPARATUS FOR PRODUCING SILICON-CONTAINING MATERIALS
PROCÉDÉ ET APPAREIL POUR PRODUIRE DES MATÉRIAUX CONTENANT DU SILICIUM

(30) Priorität: 08.08.2019 DE 102019211921
(43) Veröffentlichungstag der Anmeldung: 15.06.2022
(73) Patentinhaber: Schmid Silicon Technology GmbH, 72250 Freudenstadt (DE)
(72) Erfinder: SCHMID, Christian, 72250 Freudenstadt (DE); PETRIK, Georgij, 71032 Böblingen (DE); HAHN, Jochem, 72108 Rottenburg am Neckar (DE); FEINÄUGLE, Peter, 72250 Freudenstadt (DE)
(74) Vertreter: Ostertag & Partner Patentanwälte mbB
(86) Internationale Anmeldenummer: PCT/EP2020/071513
(87) Internationale Veröffentlichungsnummer: WO 2021/023615

(56) Entgegenhaltungen:
- EP-A2- 3 310 942
- EP-B1- 3 310 942
- DE-A1-102008 059 408
- DATABASE WPI Week 198251 Thomson Scientific, London, GB; AN 1982-10125J XP002800859, & JP S57 183369 A (SUMITOMO ELECTRIC IND CO) 11. November 1982 (1982-11-11)

## Beschreibung

Die nachfolgend beschriebene Erfindung betrifft ein Verfahren und eine Vorrichtung zur Erzeugung siliziumhaltiger Materialien.

Siliziumhaltige Materialien haben auf vielen technischen Gebieten eine große Bedeutung. So findet beispielsweise Siliziumnitrid Verwendung als Werkstoff für thermoschockbeanspruchte Bauteile. Siliziumcarbid eignet sich aufgrund seiner Härte als Schleifmittel, zur Herstellung mechanischer Bauteile, auch von Verbundwerkstoffen, oder auch als Halbleitermaterial. Mit Kohlenstoff beschichtete nano- oder mikroskalige Siliziumpartikel finden als Anodenmaterial in Lithium-Ionen-Batterien Verwendung.

Bei der Herstellung der genannten siliziumhaltigen Materialien geht man von ganz unterschiedlichen Ausgangsmaterialien aus. Zur Herstellung der mit Kohlenstoff beschichteten Siliziumpartikel werden Siliziumblöcke gemahlen, die resultierenden Partikel können unmittelbar mit Ruß oder einer anderen Kohlenstoffmodifikation beschichtet werden. Alternativ können die Partikel auch mit einem organischen Polymer beschichtet werden, das anschließend unter Sauerstoffausschluss carbonisiert wird. Siliziumnitrid wird meist durch Reaktion von reinem Silizium mit Stickstoff bei Temperaturen > 1000 °C gewonnen. Die Herstellung von Siliziumcarbid erfolgt meist nach dem Acheson-Verfahren oder durch Abscheidung aus der Dampfphase mit Chlorsilanen als Ausgangsstoffen.

Eine weitere Methode zur Herstellung von Siliziumcarbid oder Siliziumnitrid ist aus der JP S57-183369 A bekannt. Hier ist beschrieben, eine Vormischung aus ultrafeinen Siliziumpartikeln und Ammoniak oder Tetrachlorkohlenstoff sowie Stickstoff oder Argon als Trägergas zu bilden und die Vormischung in einen Plasmazustand zu überführen.Die genannten Herstellungsvarianten sind grundsätzlich für die industrielle Herstellung der genannten Materialien geeignet. Allerdings wäre es wünschenswert, bei der Herstellung der Materialien jeweils vom gleichen Ausgangsmaterial ausgehen zu können.

Zudem stellen die bekannten Verfahren die genannten siliziumhaltigen Materialien nicht immer mit dem geforderten Reinheitsgrad bereit, insbesondere im Fall von Siliziumcarbid, und es wäre daher weiterhin wünschenswert, ein diesbezüglich verbessertes Herstellungsverfahren bereitzu stellen.

Im Falle der Herstellung der mit Kohlenstoff beschichteten nano- oder mikroskaligen Siliziumpartikel wäre es wünschenswert, die zu beschichtenden Ausgangspartikel nicht erst durch einen Mahlvorgang gewinnen zu müssen.

Darüber hinaus wäre es wünschenswert, die Herstellung der genannten Materialien aus energetischer Sicht zu optimieren.

Der nachfolgend beschriebenen Erfindung lag die Aufgabe zugrunde, hierfür eine Lösung bereitzustellen. Die Lösung sollte dazu geeignet sein, siliziumhaltige Materialien wie die oben genannten in großtechnischem Maßstab zu produzieren.

Zur Lösung dieser Aufgabe schlägt die Erfindung ein Verfahren mit den in Anspruch 1 genannten Merkmalen sowie eine Vorrichtung mit den in Anspruch 12 genannten Merkmalen vor. Weiterbildungen der Erfindung sind Gegenstand von Unteransprüchen.

### Verfahren gemäß der Erfindung

Das Verfahren gemäß der Erfindung ist universell einsetzbar und eignet sich zur Erzeugung unterschiedlicher partikelförmiger siliziumhaltiger Materialien, wobei die Materialien grundsätzlich ausgehend von jeweils gleichen Ausgangsmaterialien hergestellt werden können. Das Verfahren zeichnet sich stets durch die folgenden Schritte aus:
a. Ein Gas wird in einen hocherhitzten Zustand überführt, in dem es zumindest teilweise als Plasma vorliegt, und
b. Das hocherhitzte Gas wird mit einem siliziumhaltigen ersten Ausgangsmaterial kontaktiert unter Bildung eines Gemisches umfassend das Gas sowie Silizium, und
c. zur Erzeugung der siliziumhaltigen Materialien wird dem Gas oder dem Gemisch ein zweites Ausgangsmaterial zugesetzt.

Während die Schritte a. und b. der Bereitstellung von Silizium dienen, wird in Schritt c. ein potentieller Reaktionspartner bereitgestellt, der mit dem Silizium reagieren oder ein Kompositmaterial bilden kann. Das zweite Ausgangsmaterial wird dabei derart gewählt, dass es
- mit dem Silizium in dem Gemisch unmittelbar eine chemische Reaktion eingehen kann, oder
- sich bei Kontakt mit dem hocherhitzten Gas und/oder dem Gemisch thermisch zersetzt.

Im letzteren Fall wird durch die Zersetzung ein Stoff oder ein chemisches Element freigesetzt, das mit dem Silizium reagieren oder mit dem Silizium das Kompositmaterial bilden kann.

Besonders zeichnet sich das Verfahren dadurch aus, dass
d. die Schritte a. und b. räumlich getrennt voneinander erfolgen.

Aus der DE 10 2008 059 408 A1 ist es bekannt, Monosilan (SiH₄) in einen Reaktionsraum zu injizieren, in den weiterhin ein hocherhitzter Gasstrom eingeleitet wird. Bei Kontakt mit dem Gasstrom wird das Monosilan in seine elementaren Bestandteile zersetzt. Dabei entstehendes dampfförmiges Silizium kann kondensiert werden. Bei der Kondensation bilden sich kleine Tropfen aus flüssigem Silizium. Die Tropfen werden gesammelt, so gewonnenes flüssiges Silizium kann unmittelbar, also ohne zwischenzeitliche Abkühlung, weiterverarbeitet werden, beispielsweise in einem Zonenschwebeverfahren oder einem Czochralski-Verfahren in einen Silizium-Einkristall überführt werden.

Die vorliegende Erfindung baut auf diesem Verfahren auf, wobei das Ziel des Verfahrens nicht mehr die Herstellung von Reinsilizium ist. Stattdessen wird das bei dem Verfahren bereitgestellte Silizium unmittelbar zu einem siliziumhaltigen Material weiterverarbeitet. Das Verfahren dient erfindungsgemäß nun als einheitlicher Ausgangspunkt zur Herstellung einer Vielzahl von siliziumhaltigen Materialien.

Das Grundprinzip zur Herstellung des Siliziums wurde aus der DE 10 2008 059 408 A1 übernommen: Das hocherhitzte Gas wird in einem Reaktionsraum mit dem siliziumhaltigen ersten Ausgangsmaterial kontaktiert, wobei das Gas, wenn es mit dem Ausgangsmaterial in Kontakt tritt, einen ausreichend hohe Temperatur aufweisen muss, um dieses in Abhängigkeit seiner Beschaffenheit entweder zu zersetzen, zu schmelzen oder zu verdampfen. Das dabei entstehende Silizium wird unter Nutzung der Energie, die zur Bereitstellung des Siliziums ohnehin aufgewendet werden muss, in energetisch vorteilhafter Weise unmittelbar zu dem jeweils gewünschten siliziumhaltigen Material weiterverarbeitet.

Dabei erfolgt erfindungsgemäß die Erhitzung des Gases, insbesondere die Plasmabildung, nicht innerhalb des Reaktionsraums, in dem die Kontaktierung mit dem ersten siliziumhaltigen Ausgangsmaterial erfolgt. Vielmehr erfolgen gemäß der vorliegenden Erfindung die Plasmabildung und die Kontaktierung des hocherhitzten Gases mit dem siliziumhaltigen ersten Ausgangsmaterial, wie bereits in der DE 10 2008 059 408 A1 beschrieben, räumlich getrennt voneinander.

Zur Überführung des Gases in den hocherhitzten Zustand ist eine entsprechende Einrichtung vorgesehen, bei der es sich bevorzugt um eine Plasmaerzeugungseinrichtung handelt. Diese kann in Abhängigkeit der gewünschten Reinheit des zu bildenden Siliziums gewählt werden. So eignen sich etwa Einrichtungen zur Erzeugung induktiv gekoppelter Plasmen insbesondere zur Herstellung von hochreinem Silizium, während sich die Gewinnung von Silizium geringerer Reinheit auch mit Gleichstrom-Plasmaerzeugern bewerkstelligen lässt. Bei letzteren sorgt ein zwischen Elektroden gebildeter Lichtbogen für den Energieeintrag in das Gas, um es in den hocherhitzten Zustand zu überführen.

Gleichstrom-Plasmaerzeuger können ausgesprochen einfach ausgebildet sein. Im einfachsten Fall können sie die Elektroden zur Erzeugung des Lichtbogens und eine geeignete Spannungsversorgung umfassen, wobei die Elektroden in einem Raum oder Durchlass angeordnet sind, der von dem zu erhitzenden Gas durchströmt wird.

Die erwähnte bevorzugte räumliche Trennung des Erhitzens und der Kontaktierung des hocherhitzten Gases mit dem siliziumhaltigen ersten Ausgangsmaterial bedeutet bei der Verwendung eines Gleichstrom-Plasmaerzeugers konkret, dass das Gas zunächst den Lichtbogen durchströmt, wobei es erhitzt bzw. in ein Plasma umgewandelt wird, und dann - in Strömungsrichtung hinter dem Lichtbogen - mit dem siliziumhaltigen ersten Ausgangsmaterial in Kontakt tritt. Konstruktiv wird das bevorzugt realisiert, indem die Elektroden des Gleichstrom-Plasmaerzeugers entweder in einer in dem Reaktionsraum mündenden Zuleitung angeordnet sind oder der Gleichstrom-Plasmaerzeuger dieser Zuleitung vorgeschaltet ist. So wird erreicht, dass die Erhitzung des Gases bzw. die Plasmaerzeugung abgekoppelt von der Einspeisung des siliziumhaltigen ersten Ausgangsmaterials ist und durch die Einspeisung nicht negativ beeinflusst wird. Für einen hohen Durchsatz, wie er in einem großtechnischen Verfahren gefordert ist, ist dies nach Erkenntnissen der Anmelderin essentiell.

Bei Verwendung induktiv gekoppelter Plasmen findet aus dem gleichen Grund die Kontaktierung mit dem siliziumhaltigen ersten Ausgangsmaterial außerhalb des Wirkungsbereiches der zum Einsatz kommenden Induktionsspule oder Induktionsspulen statt. Besonders bevorzugt durchströmt das Gas zunächst die Induktionsspule oder Induktionsspulen, wobei es erhitzt wird, und tritt dann - in Strömungsrichtung hinter der oder den Induktionsspulen - mit dem siliziumhaltigen ersten Ausgangsmaterial in Kontakt.

In einigen bevorzugten Ausführungsformen wird gemäß der vorliegenden Erfindung das hocherhitzte Gas nach seiner Erhitzung durch gezielte technische Maßnahmen wie dem Mischen des hocherhitzten Gases mit einem Temperiergas, welches eine vergleichsweise tiefe Temperatur hat, sogar gekühlt, bevor es mit dem siliziumhaltigen ersten Ausgangsmaterial kontaktiert wird. In Abhängigkeit des verwendeten siliziumhaltigen ersten Ausgangsmaterials sind die Temperaturen eines Plasmas nämlich keineswegs zwingend für dessen Verdampfung oder Zersetzung erforderlich. Das Temperiergas kann dem hocherhitzten Gas über einen entsprechenden Einspeisungspunkt in der für das hocherhitzte Gas vorgesehenen Zuleitung zu dem Reaktionsraum zugemischt werden.

Weiterhin kann es auch bevorzugt sein, das aus dem obigen Schritt b. resultierende Gemisch oder das aus Schritt c. nach Zugabe des zweiten Ausgangsmaterials resultierende Gemisch mit Hilfe eines Temperiergases abzukühlen.

Bei dem Gas, das in den hocherhitzten Zustand überführt wird, handelt es sich bevorzugt um Wasserstoff oder um ein Edelgas wie Argon oder um Stickstoff oder eine Mischung der genannten Gase. Geeignet ist beispielsweise eine Mischung aus Argon und Wasserstoff, die das Argon z.B. in einem Anteil von 10 Vol.-% bis 90 Vol.-% enthält.

Mit Hilfe der Einrichtung zur Erzeugung des hocherhitzten Gases wird das Gas bevorzugt auf eine Temperatur im Bereich von 1500 °C bis 24000 °C, bevorzugt 2000 °C bis 20000 °C, besonders bevorzugt von 2000 °C bis 15000 °C, erhitzt.

Als Temperiergas können beispielsweise Wasserstoff oder ein Edelgas wie Argon oder Stickstoff oder eine Mischung der genannten Gase dienen.

Durch die räumliche Trennung der Erhitzung des Gases und der Kontaktierung des Gases mit dem siliziumhaltigen Ausgangsmaterial ist gewährleistet, dass auch größere Mengen des siliziumhaltigen Ausgangsmaterials umgesetzt werden können, ohne dass dies die Stabilität des Plasmas beeinträchtigt.

Auch das siliziumhaltige erste Ausgangsmaterial kann in Abhängigkeit der gewünschten Reinheit gewählt werden. Zur Erzeugung von Materialien hoher stofflicher Reinheit eignen sich als siliziumhaltiges erstes Ausgangsmaterial insbesondere gasförmige siliziumhaltige Ausgangsmaterialien wie das bereits erwähnte Monosilan oder Trichlorsilan (SiHCl₃). Letzteres weist gegenüber Monosilan den Nachteil auf, dass es beim Kontakt mit dem hocherhitzten Gas chemisch aggressive Zersetzungsprodukte bildet. Bei der Zersetzung von Monosilan entstehen hingegen nur Silizium und Wasserstoff.

In vielen Fällen kann auch von partikelförmigem metallischem Silizium als erstem Ausgangsmaterial ausgegangen werden. Dabei kann es sich insbesondere um Partikel aus metallurgischem Silizium handeln. Wenn Materialien hoher stofflicher Reinheit hergestellt werden sollen, können als metallisches Silizium aber auch Polysilizium oder kristallines Silizium eingesetzt werden. Das metallische Silizium schmilzt oder verdampft bei Kontakt mit dem hocherhitzten Gas, insbesondere dem Plasma. Beispielsweise kann das partikelförmige Silizium mit Hilfe eines Trägergasstroms, beispielsweise Wasserstoff, in den Reaktionsraum eingespeist werden.

Als partikelförmiges siliziumhaltiges Ausgangsmaterial kann weiterhin auch Quarz in Partikelform dienen. Quarz kann bei Kontakt mit einem Wasserstoffplasma zu metallischem Silizium reduziert werden.

Grundsätzlich können im Übrigen auch partikelförmige Siliziumlegierungen wie z.B. partikelförmiges Ferrosilizium als partikelförmiges siliziumhaltiges Ausgangsmaterial eingesetzt werden.

Unter "partikelförmig" soll im Übrigen bevorzugt verstanden werden, dass das siliziumhaltige erste Ausgangsmaterial in Form von Partikeln mit einer mittleren Größe zwischen 10 nm und 100 µm vorliegt. Bevorzugt ist das partikelförmige siliziumhaltige erste Ausgangsmaterial frei von Partikeln mit Größen > 100 µm.

Wie aus den obigen Ausführungen hervorgeht, liegt das Silizium in dem aus der Kontaktierung des hocherhitzten Gases mit dem siliziumhaltigen ersten Ausgangsmaterial resultierenden Gemisch bevorzugt dampfförmig vor, in Abhängigkeit der Kontaktierungsbedingungen gegebenenfalls auch zumindest teilweise in Form sehr kleiner Tropfen.

Betreffend die obigen Schritte b. und c., in denen das hocherhitzte Gas und das erste Ausgangsmaterial kontaktiert werden und das zweite Ausgangsmaterial dem Gas oder dem Gemisch zugesetzt wird, gibt es mehrere bevorzugte Vorgehensweisen:
- Gemäß einer bevorzugten Vorgehensweise werden das erste und das zweite Ausgangsmaterial gleichzeitig mit dem hocherhitzten Gas kontaktiert, beispielsweise simultan in einen Strom aus dem hocherhitzten Gas eingespeist. Das sich dabei bildende Gemisch umfasst dann neben dem Silizium und dem hocherhitzten Gas gleich auch das zweite Ausgangsmaterial und/oder dessen Zersetzungsprodukte sowie gegebenenfalls auch gleich Produkte aus einer Reaktion des zweiten Ausgangsmaterials mit dem Silizium.
- Gemäß einer weiteren bevorzugten Vorgehensweise wird zunächst das Gemisch aus dem Silizium und dem hocherhitzten Gas gebildet, dem in einem Folgeschritt das zweite Ausgangsmaterial zugesetzt wird.
- Grundsätzlich ist es auch möglich, zunächst ein Gemisch aus dem zweiten Ausgangsmaterial und dem hocherhitzten Gas zu bilden und erst in einem anschließenden Schritt das erste Ausgangsmaterial zuzusetzen. Dies kann insbesondere dann bevorzugt sein, wenn das zweite Ausgangsmaterial mit dem Silizium in dem Gemisch unmittelbar eine chemische Reaktion eingehen kann, also nicht erst eine vorgeschaltete thermische Zersetzung des zweiten Ausgangsmaterials erfolgen muss.
- Gemäß einigen bevorzugten Vorgehensweisen ist es auch möglich, dass es sich bei dem Gas, das in den hocherhitzten Zustand überführt wird, um das zweite Ausgangsmaterial handelt, oder dass das zweite Ausgangsmaterial dem Gas zumindest anteilig zugesetzt wird. Die Kontaktierung mit dem Silizium erfolgt dann unmittelbar nach der Kontaktierung des hocherhitzten Gases mit dem siliziumhaltigen ersten Ausgangsmaterial.

In einer **ersten, besonders bevorzugten Variante** des Verfahrens, die sich insbesondere zur Erzeugung von Siliziumcarbid und Siliziumnitrid eignet, zeichnet sich das Verfahren durch mindestens einen der unmittelbar folgenden Schritte a. bis c. aus:
a. Das Kontaktieren des hocherhitzten Gases mit dem siliziumhaltigen ersten Ausgangsmaterial unter Bildung des Gemisches umfassend das Gas sowie das Silizium erfolgt bei einer Kontaktierungstemperatur, die oberhalb der Zersetzungstemperatur des zu erzeugenden siliziumhaltigen Materials liegt.
b. Das Silizium in dem Gemisch wird mit dem zweiten Ausgangsmaterial bei einer Kontaktierungstemperatur kontaktiert, die oberhalb der Zersetzungstemperatur des zu erzeugenden siliziumhaltigen Materials liegt.
c. Das aus der Kontaktierung des Siliziums und des zweiten Ausgangsmaterials resultierende Gemisch wird zur Erzeugung von Partikeln aus dem siliziumhaltigen Material auf eine Temperatur < der Zersetzungstemperatur des zu erzeugenden siliziumhaltigen Materials abgekühlt.

Besonders bevorzugt sind die unmittelbar vorstehenden Merkmale a. bis c. in Kombination miteinander realisiert.

Die Schritte a. und b. können, wie oben dargelegt, (A) zeitgleich oder sequentiell erfolgen. Im letzteren Fall wird entweder (B) zuerst das erste Ausgangsmaterial dem hocherhitzten Gas zugesetzt, gefolgt von einer Einspeisung des zweiten Ausgangsmaterials in das aus Schritt a. resultierende Gemisch, oder (C) das zweite Ausgangsmaterial ist mindestens Teil des hocherhitzten Gases, wenn dieses mit dem ersten Ausgangsmaterial kontaktiert wird.

Im Fall (A) meinen die Kontaktierungstemperaturen in den Schritten a. und b. die Temperatur des Gemisches, das aus der Kontaktierung des hocherhitzten Gases mit dem ersten und dem zweiten Ausgangsmaterial resultiert.

Im Fall (B) meint die Kontaktierungstemperatur in Schritt a. die Temperatur des aus Schritt a. resultierenden Gemisches während die Kontaktierungstemperatur in Schritt b. die Temperatur des aus Schritt b. resultierenden Gemisches meint. Bevorzugt sind die Kontaktierungstemperaturen in den Schritten a. und b. im Wesentlichen die gleichen.

Im Fall (C) meinen die Kontaktierungstemperaturen in den Schritten a. und b. die Temperatur des Gemisches, das aus der Kontaktierung des hocherhitzten, mindestens teilweise aus dem zweiten Ausgangsmaterial bestehenden Gases mit dem ersten Ausgangsmaterial resultiert.

Besonders bevorzugt wird als Kontaktierungstemperatur in Schritt a. eine Temperatur < der Siedetemperatur von Silizium und > der Zersetzungstemperatur des zu erzeugenden siliziumhaltigen Materials gewählt.

In Schritt c. wird das aus der Kontaktierung des Siliziums und des zweiten Ausgangsmaterials resultierende Gemisch besonders bevorzugt auf eine Temperatur < der Zersetzungstemperatur des zu erzeugenden siliziumhaltigen Materials und > der Schmelztemperatur von Silizium abgekühlt.

Die Wahl der Kontaktierungstemperaturen oberhalb der Zersetzungstemperatur des zu erzeugenden siliziumhaltigen Materials hat zur Folge, dass die Partikel aus dem siliziumhaltigen Material erst in Schritt c. gebildet werden können. Die Zeitdauer, in der das aus der Kontaktierung des Siliziums und des zweiten Ausgangsmaterials resultierende Gemisch oberhalb der Zersetzungstemperatur gehalten wird, kann Einfluss auf die Größe der aus Schritt c. resultierenden Partikel haben. Es gilt der Grundsatz, dass die Größe der Partikel mit größerer Zeitdauer zunimmt, vermutlich da sich Siliziumatome in dem Gemisch zu größeren Tropfen zusammenlagern.

Damit die Zersetzungstemperatur in den Schritten a. und b, nicht unterschritten wird, müssen in den genannten Fällen die Mischungsverhältnisse und Ausgangstemperaturen der jeweils beteiligten Komponenten beachtet werden.

Schritt c. umfasst bevorzugt zwei Teilschritte, nämlich
- erstens die erwähnte Abkühlung des Gemisches auf eine Temperatur > der Schmelztemperatur von Silizium und < der Zersetzungstemperatur des zu erzeugenden siliziumhaltigen Materials und
- zweitens eine anschließende Abkühlung auf eine Temperatur < dem Schmelzpunkt von Silizium, beispielsweise durch Quenchen.

Im zweiten Teilschritt erfolgt bevorzugt eine Abkühlung auf eine Temperatur < 50 °C.

Das Abkühlen erfolgt bevorzugt mit Hilfe eines Temperiergases. Hierbei kann es sich beispielsweise um ein Neutralgas wie Argon oder um Wasserstoff handeln.

In einer ersten bevorzugten Weiterbildung der ersten, besonders bevorzugten Variante des Verfahrens, zeichnet sich dieses durch mindestens eines der unmittelbar folgenden Merkmale a. und b. aus:
a. Das erste Ausgangsmaterial ist Monosilan oder metallisches Silizium in Partikelform, insbesondere Monosilan.
b. Das zweite Ausgangsmaterial ist eine Kohlenstoffquelle, die bei Kontakt mit dem hocherhitzten Gas Kohlenstoff freisetzt.

Besonders bevorzugt sind die unmittelbar vorstehenden Merkmale a. und b. in Kombination miteinander realisiert.

Wenn das erste Ausgangsmaterial metallisches Silizium in Partikelform ist, wird in dieser ersten bevorzugten Weiterbildung als Kontaktierungstemperatur in Schritt a. besonders bevorzugt eine Temperatur > der Siedetemperatur von Silizium eingestellt.

Erfindungsgemäß besonders bevorzugt werden in dieser Weiterbildung also aus Monosilan Silizium und aus der Kohlenstoffquelle Kohlenstoff gebildet, welche miteinander unter den Bedingungen in dieser Verfahrensvariante zu Siliziumcarbid, bevorzugt mit der stöchiometrischen Zusammensetzung SiC, reagieren.

Die Zersetzungstemperatur von Siliziumcarbid liegt bei ca. 2830 °C. Die Kontaktierungstemperaturen liegen in dieser Weiterbildung also bevorzugt oberhalb dieses Werts. Wird die Temperatur des Gemischs enthaltend das Silizium und den Kohlenstoff auf einen Wert unterhalb dieser Temperatur abgesenkt, setzt die Bildung festen Siliziumcarbids ein.

Bei der Kohlenstoffquelle handelt es sich bevorzugt um einen Kohlenwasserstoff, beispielsweise um Methan, Propen, Acetylen und/oder Ethen.

In einer zweiten bevorzugten Weiterbildung der ersten, besonders bevorzugten Variante des Verfahrens, zeichnet sich dieses durch mindestens eines der unmittelbar folgenden Merkmale a. und b. aus:
a. Das erste Ausgangsmaterial ist Monosilan oder metallisches Silizium in Partikelform, insbesondere Monosilan.
b. Das zweite Ausgangsmaterial ist Stickstoff oder eine Stickstoffquelle, die bei Kontakt mit dem hocherhitzten Gas Stickstoff freisetzt.

Besonders bevorzugt sind die unmittelbar vorstehenden Merkmale a. und b. in Kombination miteinander realisiert.

Wenn das erste Ausgangsmaterial metallisches Silizium in Partikelform ist, wird auch in dieser zweiten bevorzugten Weiterbildung als Kontaktierungstemperatur in Schritt a. besonders bevorzugt eine Temperatur > der Siedetemperatur von Silizium eingestellt.

Erfindungsgemäß besonders bevorzugt wird in dieser Weiterbildung also aus Monosilan Silizium gebildet, das dann mit dem Stickstoff unter den Bedingungen in dieser Verfahrensvariante zu Siliziumnitrid, bevorzugt mit der Stöchiometrie Si₃N₄, reagiert.

Die Zersetzungstemperatur von Siliziumnitrid liegt bei ca. 1900 °C. Die Kontaktierungstemperaturen liegen in dieser Weiterbildung also bevorzugt oberhalb dieses Werts. Wird die Temperatur des Gemischs enthaltend das Silizium und den Stickstoff auf einen Wert unterhalb dieser Temperatur abgesenkt, setzt die Bildung festen Siliziumnitrids ein.

Bei der Stickstoffquelle handelt es sich beispielsweise um Ammoniak.

Ganz allgemein lassen sich mit dem erfindungsgemäßen Verfahren, insbesondere auch der vorstehend beschriebenen ersten, besonders bevorzugten Variante des Verfahrens, Partikel bilden, die sich dadurch auszeichnen, dass sie keine scharfen Ecken oder Kanten aufweisen, insbesondere im Wesentlichen kugelförmig ausgebildet sind. Setzt man Monosilan als erstes Ausgangsmaterial ein, so wird dieses unter Bildung von Siliziumatomen zersetzt, die anschließend zu kleinen, näherungsweise kugelförmigen Tropfen kondensieren. Geht man von partikelförmigem metallischem Silizium als erstem Ausgangsmaterial aus, so werden die eingesetzten Partikel mindestens oberflächlich geschmolzen, bevorzugt vollständig geschmolzen, so dass Ecken und Kanten verschwinden und gleichfalls näherungsweise kugelförmige Tropfen resultieren. Die gebildeten Tropfen können dann mit dem zweiten Ausgangsmaterial oder einem Bestandteil des zweiten Ausgangsmaterials reagieren. Nach einer Abkühlung resultieren dann beispielsweise näherungsweise kugelförmige Siliziumcarbid- oder Siliziumnitridpartikel.

Zur Herstellung von Partikeln mit sehr kleinen Durchmessern (bis zu maximal 150 nm) geht man bei allen Varianten des erfindungsgemäßen Verfahrens in bevorzugten Ausführungsformen von Monosilan als erstem Ausgangsmaterial aus. Zur Herstellung von größeren Partikeln (bis zu 10 µm) geht man bevorzugt von metallischem Silizium als erstem Ausgangsmaterial aus.

Das gemäß der vorstehend beschriebenen ersten, besonders bevorzugten Variante des Verfahrens gebildete Siliziumcarbid und Siliziumnitrid wird bevorzugt in Form zumindest näherungsweise kugelförmiger Partikel ausgebildet, die bevorzugt eine mittlere Größe (d50) im Bereich von 1 µm bis 10 µm aufweisen.

In einer **zweiten, besonders bevorzugten Variante** des Verfahrens, die sich insbesondere zur Erzeugung von mit Kohlenstoff beschichteten Siliziumpartikeln eignet, zeichnet sich das Verfahren durch mindestens einen der unmittelbar folgenden Schritte a. bis c. aus:
a. Das Kontaktieren des hocherhitzten Gases mit dem siliziumhaltigen ersten Ausgangsmaterial unter Bildung des Gemisches umfassend das Gas sowie das Silizium erfolgt bei einer Kontaktierungstemperatur, die oberhalb der Siedetemperatur von Silizium liegt.
b. Das Gemisch umfassend das Gas sowie das Silizium wird zur Kontaktierung mit dem zweiten Ausgangsmaterial unter Erzeugung von Si-Partikeln auf eine Temperatur < der Schmelztemperaturvon Silizium abgekühlt.
c. Die Siliziumpartikel werden mit dem zweiten Ausgangsmaterial bei einer Kontaktierungstemperatur kontaktiert, die > als die Zersetzungstemperatur des zweiten Ausgangsmaterials und < als die Schmelztemperatur von Silizium ist.

Die Schritte a. und c. können in dieser Variante ausschließlich sequentiell erfolgen. Hier wird also zuerst das erste Ausgangsmaterial dem hocherhitzten Gas zugesetzt, gefolgt von einer Abkühlung des aus Schritt a. resultierenden Gemisch. Erst dann wird das zweite Ausgangsmaterial mit dem ersten Ausgangsmaterial kontaktiert.

Die Kontaktierungstemperatur in Schritt a. meint die Temperatur des aus Schritt a. resultierenden Gemisches, während die Kontaktierungstemperatur in Schritt c. die Temperatur des aus Schritt c. resultierenden Gemisches meint. Die Kontaktierungstemperatur in Schritt a. ist auf jeden Fall höher als die Kontaktierungstemperatur in Schritt c..

Die Wahl der Kontaktierungstemperatur in Schritt a. oberhalb der Siedetemperatur von Silizium hat zur Folge, dass Silizium dampfförmig und/oder in Form kleiner Tropfen gebildet werden kann. Bei der anschließenden Abkühlung werden Siliziumpartikel gebildet, die allerdings noch eine ausreichend hohe Temperatur aufweisen, dass sich das zweite Ausgangsmaterial an ihrer Oberfläche zersetzen kann. Der dabei entstehende Kohlenstoff lagert sich an der Oberfläche der Siliziumpartikel an, es bilden sich Silizium-Kohlenstoff-Kompositpartikel.

Das Abkühlen in Schritt b. erfolgt bevorzugt mit Hilfe eines Temperiergases. Hierbei kann es sich beispielsweise um ein Neutralgas wie Argon oder um Wasserstoff handeln.

Nach Schritt c. folgt bevorzugt eine Abkühlung auf eine Temperatur < 50 °C, beispielsweise durch Quenchen.

In einer bevorzugten Weiterbildung der zweiten, besonders bevorzugten Variante des Verfahrens, zeichnet sich dieses durch mindestens eines der unmittelbar folgenden Merkmale a. und b. aus:
a. Das erste Ausgangsmaterial ist Monosilan oder metallisches Silizium in Partikelform, insbesondere metallisches Silizium in Partikelform.
b. Das zweite Ausgangsmaterial ist eine Kohlenstoffquelle, die bei Kontakt mit den Siliziumpartikeln Kohlenstoff freisetzt.

Besonders bevorzugt sind die unmittelbar vorstehenden Merkmale a. und b. in Kombination miteinander realisiert.

Erfindungsgemäß besonders bevorzugt werden in dieser Weiterbildung also metallisches Silizium in Partikelform geschmolzen und/oder verdampft und aus der Kohlenstoffquelle Kohlenstoff gebildet. Das Silizium und der Kohlenstoff reagieren hier nicht miteinander, da sie bei vergleichsweise niedrigen Temperaturen kontaktiert werden. Stattdessen bildet sich ein Kompositmaterial.

Bei der Kohlenstoffquelle handelt es sich bevorzugt um einen Kohlenwasserstoff, beispielsweise um Methan Propen. Acetylen und/oder Ethen.

Die gemäß der vorstehend beschriebenen zweiten, besonders bevorzugten Variante des Verfahrens gebildeten mit Kohlenstoff beschichteten Siliziumpartikel werden bevorzugt in Form zumindest näherungsweise kugelförmiger Partikel ausgebildet, die bevorzugt einen maximalen Durchmesser von 150 nm aufweisen.

In einer **dritten, besonders bevorzugten Variante** des Verfahrens, die sich wie die zweite Variante insbesondere zur Erzeugung von mit Kohlenstoff beschichteten Siliziumpartikeln eignet, zeichnet sich das Verfahren durch mindestens einen der unmittelbar folgenden Schritte a. bis c. aus:
a. Das Kontaktieren des hocherhitzten Gases mit dem siliziumhaltigen ersten Ausgangsmaterial unter Bildung des Gemisches umfassend das Gas sowie das Silizium erfolgt bei einer Kontaktierungstemperatur, die oberhalb der Schmelztemperatur von Silizium liegt.
b. Das Gemisch umfassend das Gas sowie das Silizium wird zur Kontaktierung mit dem zweiten Ausgangsmaterial unter Erzeugung von Siliziumpartikeln auf eine Temperatur < der Schmelztemperatur von Silizium abgekühlt.
c. Die Siliziumpartikel werden mit dem zweiten Ausgangsmaterial bei einer Kontaktierungstemperatur kontaktiert, die > als die Zersetzungstemperatur des zweiten Ausgangsmaterials und < als die Schmelztemperatur von Silizium ist.

Die Schritte a. und c. können auch in dieser Variante ausschließlich sequentiell erfolgen. Hier wird also zuerst das erste Ausgangsmaterial dem hocherhitzten Gas zugesetzt, gefolgt von einer Abkühlung des aus Schritt a. resultierenden Gemisch. Erst dann wird das zweite Ausgangsmaterial mit dem ersten Ausgangsmaterial kontaktiert.

Die Kontaktierungstemperatur in Schritt a. meint die Temperatur des aus Schritt a. resultierenden Gemisches, während die Kontaktierungstemperatur in Schritt c. die Temperatur des aus Schritt c. resultierenden Gemisches meint. Die Kontaktierungstemperatur in Schritt a. ist auf jeden Fall höher als die Kontaktierungstemperatur in Schritt c..

Die Wahl der Kontaktierungstemperatur in Schritt a. oberhalb der Schmelztemperatur von Silizium hat zur Folge, dass Silizium dampfförmig und/oder in Form kleiner Tropfen gebildet werden kann. Bei der anschließenden Abkühlung werden Siliziumpartikel gebildet, die allerdings noch eine ausreichend hohe Temperatur aufweisen, dass sich das zweite Ausgangsmaterial an ihrer Oberfläche zersetzen kann. Der dabei entstehende Kohlenstoff lagert sich an der Oberfläche der Siliziumpartikel an, es bilden sich auch hier Silizium-Kohlenstoff-Kompositpartikel.

Das Abkühlen in Schritt b. erfolgt bevorzugt mit Hilfe eines Temperiergases. Hierbei kann es sich beispielsweise um ein Neutralgas wie Argon oder um Wasserstoff handeln.

Nach Schritt c. folgt bevorzugt eine Abkühlung auf eine Temperatur < 50 °C, beispielsweise durch Quenchen.

In einer bevorzugten Weiterbildung der dritten, besonders bevorzugten Variante des Verfahrens, zeichnet sich dieses durch mindestens eines der unmittelbar folgenden Merkmale a. und b. aus:
a. Das erste Ausgangsmaterial ist Monosilan.
b. Das zweite Ausgangsmaterial ist eine Kohlenstoffquelle, die bei Kontakt mit den im vorstehenden Schritt b. durch das Abkühlen auf eine Temperatur < der Schmelztemperatur von Silizium erzeugten Siliziumpartikeln Kohlenstoff freisetzt.

Besonders bevorzugt sind die unmittelbar vorstehenden Merkmale a. und b. in Kombination miteinander realisiert.

Erfindungsgemäß besonders bevorzugt werden in dieser Weiterbildung also Silizium aus Monosilan und Kohlenstoff aus der Kohlenstoffquelle gebildet. Das Silizium und der Kohlenstoff reagieren auch hier nicht miteinander. Stattdessen bildet sich auch hier ein Kompositmaterial.

Bei der Kohlenstoffquelle handelt es sich bevorzugt um einen Kohlenwasserstoff, beispielsweise um Methan, Propen, Acetylen und/oder Ethen.

Die gemäß der vorstehend beschriebenen dritten, besonders bevorzugten Variante des Verfahrens gebildeten mit Kohlenstoff beschichteten Siliziumpartikel werden gleichfalls bevorzugt in Form zumindest näherungsweise kugelförmiger Partikel ausgebildet, die bevorzugt einen maximalen Durchmesser von 150 nm aufweisen.

In einer **vierten, besonders bevorzugten Variante** des Verfahrens, die sich wie die erste Variante insbesondere zur Erzeugung von Siliziumcarbid und Siliziumnitrid eignet, zeichnet sich das Verfahren durch mindestens einen der unmittelbar folgenden Schritte a. und b. aus:
a. Das Kontaktieren des hocherhitzten Gases mit dem siliziumhaltigen ersten Ausgangsmaterial unter Bildung des Gemisches umfassend das Gas sowie das Silizium erfolgt bei einer Kontaktierungstemperatur, die oberhalb der Schmelztemperatur von Silizium liegt.
b. Das Silizium in dem Gemisch wird mit dem zweiten Ausgangsmaterial bei einer Kontaktierungstemperatur kontaktiert, die unterhalb der Zersetzungstemperatur des zu erzeugenden siliziumhaltigen Materials liegt, insbesondere bei einer Temperatur < der Zersetzungstemperatur des zu erzeugenden siliziumhaltigen Materials und > der Schmelztemperatur von Silizium.

Besonders bevorzugt sind die unmittelbar vorstehenden Merkmale a. und b. in Kombination miteinander realisiert.

Die Schritte a. und b. können wie in Variante 1 (A) zeitgleich oder sequentiell erfolgen. Im letzteren Fall wird entweder (B) zuerst das erste Ausgangsmaterial dem hocherhitzten Gas zugesetzt, gefolgt von einer Einspeisung des zweiten Ausgangsmaterials in das aus Schritt a. resultierende Gemisch, oder (C) das zweite Ausgangsmaterial ist mindestens Teil des hocherhitzten Gases, wenn dieses mit dem ersten Ausgangsmaterial kontaktiert wird.

Im Fall (A) meinen die Kontaktierungstemperaturen in den Schritten a. und b. die Temperatur des Gemisches, das aus der Kontaktierung des hocherhitzten Gases mit dem ersten und dem zweiten Ausgangsmaterial resultiert.

Im Fall (B) meint die Kontaktierungstemperatur in Schritt a. die Temperatur des aus Schritt a. resultierenden Gemisches während die Kontaktierungstemperatur in Schritt b. die Temperatur des aus Schritt b. resultierenden Gemisches meint. Bevorzugt sind die Kontaktierungstemperaturen in den Schritten a. und b. im Wesentlichen die gleichen.

Im Fall (C) meinen die Kontaktierungstemperaturen in den Schritten a. und b. die Temperatur des Gemisches, das aus der Kontaktierung des hocherhitzten, mindestens teilweise aus dem zweiten Ausgangsmaterial bestehenden Gases mit dem ersten Ausgangsmaterial resultiert.

Besonders bevorzugt wird als Kontaktierungstemperatur in Schritt a. eine Temperatur > der Schmelztemperatur von Silizium und < 2500 °C gewählt. Damit wird Silizium in Schritt a. vor allem in Form kleiner Tropfen, gegebenenfalls teilweise auch dampfförmig, gewonnen.

Die Wahl der Kontaktierungstemperatur in Schritt b. unterhalb der Zersetzungstemperatur des zu erzeugenden siliziumhaltigen Materials hat zur Folge, dass unmittelbar nach der Zugabe des zweiten Ausgangsmaterials Partikel aus dem siliziumhaltigen Material gebildet werden können. Die Zeitdauer, die zwischen der Zugabe des ersten und des zweiten Ausgangsmaterials verstreicht, kann Einfluss auf die Größe der aus Schritt b. resultierenden Partikel haben. Es gilt der Grundsatz, dass die Größe der Partikel mit größerer Zeitdauer zunimmt, vermutlich da sich Siliziumatome in dem Gemisch zu größeren Tropfen zusammenlagern.

An Schritt c. schließt sich bevorzugt eine Abkühlung auf eine Temperatur < 50 °C, beispielsweise durch Quenchen, an.

In einer ersten bevorzugten Weiterbildung der vierten, besonders bevorzugten Variante des Verfahrens, zeichnet sich dieses durch mindestens eines der unmittelbar folgenden Merkmale a. und b. aus:
a. Das erste Ausgangsmaterial ist Monosilan oder metallisches Silizium in Partikelform, insbesondere Monosilan.
b. Das zweite Ausgangsmaterial ist eine Kohlenstoffquelle, die bei Kontakt mit dem Gemisch Kohlenstoff freisetzt.

Besonders bevorzugt sind die unmittelbar vorstehenden Merkmale a. und b. in Kombination miteinander realisiert.

Erfindungsgemäß besonders bevorzugt werden in dieser Weiterbildung also aus Monosilan Silizium und aus der Kohlenstoffquelle Kohlenstoff gebildet, welche miteinander unter den Bedingungen in dieser Verfahrensvariante zu Siliziumcarbid, bevorzugt mit der stöchiometrischen Zusammensetzung SiC, reagieren.

Die Zersetzungstemperatur von Siliziumcarbid liegt, wie oben bereits erwähnt, bei ca. 2830 °C. Die bevorzugte Kontaktierungstemperatur in Schritt a. liegt in dieser Weiterbildung also bevorzugt unterhalb dieses Werts. In Schritt b. wird die Kontaktierungstemperatur bevorzugt ebenfalls auf maximal 2500 °C eingestellt. Die Kontaktierungstemperaturen in den Schritten a. und b. sind in dieser Weiterbildung also bevorzugt im Wesentlichen die gleichen. Ein Kühlen zwischen den Schritten a. und b. ist hier nicht erforderlich.

Bei der Kohlenstoffquelle handelt es sich bevorzugt um einen Kohlenwasserstoff, beispielsweise um Methan, Propen, Acetylen und/oder Ethen.

In einer zweiten bevorzugten Weiterbildung der vierten, besonders bevorzugten Variante des Verfahrens, zeichnet sich dieses durch mindestens eines der unmittelbar folgenden Merkmale a. und b. aus:
a. Das erste Ausgangsmaterial ist Monosilan oder metallisches Silizium in Partikelform, insbesondere Monosilan.
b. Das zweite Ausgangsmaterial ist Stickstoff oder eine Stickstoffquelle, die bei Kontakt mit dem Gemisch Stickstoff freisetzt.

Besonders bevorzugt sind die unmittelbar vorstehenden Merkmale a. und b. in Kombination miteinander realisiert.

Erfindungsgemäß besonders bevorzugt wird in dieser Weiterbildung also aus Monosilan Silizium gebildet, das dann mit Stickstoff unter den Bedingungen in dieser Verfahrensvariante zu Siliziumnitrid, bevorzugt mit der Stöchiometrie Si₃N₄, reagiert.

Die Zersetzungstemperatur von Siliziumnitrid liegt, wie oben bereits erwähnt, bei ca. 1900 °C. Die Kontaktierungstemperatur in Schritt a. der beschriebenen vierten bevorzugten Variante liegt also mit einem bevorzugten maximalen Wert von 2500 °C gegebenenfalls oberhalb dieses Werts. Daher kann es erforderlich sein, das aus Schritt a. resultierende Gemisch vor der Kontaktierung in Schritt b. der vierten Variante abzukühlen, um die für den Schritt b. erforderliche Kontaktierungstemperatur < der Zersetzungstemperatur von Siliziumnitrid zu erreichen.

Das Abkühlen erfolgt bevorzugt mit Hilfe eines Temperiergases. Hierbei kann es sich beispielsweise um ein Neutralgas wie Argon oder um Wasserstoff handeln.

Bei der Stickstoffquelle handelt es sich beispielsweise um Ammoniak.

Das gemäß der vorstehend beschriebenen vierten, besonders bevorzugten Variante des Verfahrens gebildete Siliziumcarbid und Siliziumnitrid wird bevorzugt in Form zumindest näherungsweise kugelförmiger Partikel ausgebildet, die bevorzugt eine mittlere Größe (d50) im Bereich von 1 µm bis 10 µm aufweisen.

### Vorrichtung gemäß der Erfindung

Nachfolgend wird eine zur Durchführung des Verfahrens geeignete Vorrichtung beschrieben. Eine solche zeichnet sich stets durch die unmittelbar folgenden Merkmale a. bis d. aus:
a. Die Vorrichtung umfasst eine Einrichtung, mit der ein Gas in einen hocherhitzten Zustand, in dem es zumindest teilweise als Plasma vorliegt, überführt werden kann, und
b. Die Vorrichtung umfasst einen Reaktionsraum und eine darin mündende erste Zuleitung für das hocherhitzte Gas, und
c. Die Vorrichtung umfasst eine zweite Zuleitung, die unmittelbar in den Reaktionsraum mündet und durch welche ein siliziumhaltiges erstes Ausgangsmaterial unter Bildung eines Gemisches umfassend das Gas sowie Silizium in den Reaktionsraum eingespeist werden kann, und
d. Die Vorrichtung umfasst eine dritte Zuleitung, durch welche ein zweites Ausgangsmaterial,
   - welches mit dem Silizium in dem Gemisch unmittelbar eine chemische Reaktion eingehen kann, oder
   - welches sich bei Kontakt mit dem hocherhitzten Gas und/oder dem Gemisch thermisch zersetzt,
   in die Vorrichtung eingespeist werden kann.

Die Einrichtung zur Überführung des Gases in den hocherhitzten Zustand sowie deren mögliche Ausgestaltungen zur Realisierung der räumlichen Trennung des Erhitzens und der Kontaktierung des hocherhitzten Gases mit dem siliziumhaltigen ersten Ausgangsmaterial wurden bereits im Zusammenhang mit dem erfindungsgemäßen Verfahren ausführlich beschrieben.

Der Reaktionsraum, in dem das siliziumhaltige erste Ausgangsmaterial mit dem hocherhitzten Gas kontaktiert wird, muss hitzebeständig ausgebildet sein, um den thermischen Belastungen durch das hocherhitzte Gas standhalten zu können. Beispielsweise kann der Reaktionsraum hierzu mit temperaturbeständigen Materialien wie Graphit ausgekleidet sein oder aus solchen Materialien bestehen. Insbesondere können die Wände des Reaktionsraums, insbesondere die erwähnte Seitenwand und das erwähnte Abschlusselement, zumindest teilweise oder vollständig aus solchen Materialien bestehen. Alternativ oder zusätzlich kann der Reaktionsraum eine thermische Isolierung umfassen, die ihn von seiner Umgebung thermisch abschirmt.

Die erste Zuleitung für das hocherhitzte Gas bedarf keiner besonderen Ausgestaltung. Bevorzugt mündet sie senkrecht von oben in den Reaktorraum. Die zweite Zuleitung hingegen weist bevorzugt eine besondere Ausgestaltung auf, um zu vermeiden, dass ihre Mündungsöffnung in den Reaktionsraum durch feste Siliziumabscheidungen blockiert wird.

Bevorzugt umfasst sie eine Düse mit einem Düsenkanal, der unmittelbar in den Reaktionsraum mündet und durch welchen das erste Ausgangsmaterial in den Reaktionsraum eingespeist werden kann. Die Vorrichtung umfasst bevorzugt eine Einrichtung, die es ermöglicht, ein Inertgas derart in den Reaktionsraum einzuleiten, dass es die Mündungsöffnung des Düsenkanals vor einer von dem hocherhitzten Gas ausgehenden thermischen Belastung schützt. Das Inertgas bildet eine Art thermische Barriere, die die Mündungsöffnung des Düsenkanals von dem hocherhitzten Gas abschirmt und somit vermeidet, dass ein in den Reaktionsraum eintretendes siliziumhaltiges Ausgangsmaterial unmittelbar an der Mündungsöffnung zersetzt oder aufgeschmolzen wird. Stattdessen können die Zersetzung und/oder das Schmelzen des siliziumhaltigen Ausgangsmaterials beabstandet von der Mündungsöffnung erfolgen.

Als Inertgas wird erfindungsgemäß bevorzugt ein Gas verwendet, das unter den in dem Reaktionsraum herrschenden Bedingungen in relevantem Umfang weder mit dem siliziumhaltigen Ausgangsmaterial noch mit gebildetem Silizium reagieren kann. Geeignet sind grundsätzlich die gleichen Gase, die in der Einrichtung zur Erzeugung des hocherhitzten Gases erhitzt werden, also insbesondere Wasserstoff, Edelgase wie Argon und Mischungen davon.

In einer bevorzugten Weiterbildung der Erfindung zeichnet sich die Vorrichtung durch mindestens eines der unmittelbar folgenden Merkmale a. bis c. aus:
a. Die Düse ist eine Mehrstoffdüse mit dem Düsenkanal zur Einspeisung des siliziumhaltigen ersten Ausgangsmaterials als erstem Düsenkanal.
b. Die Mehrstoffdüse umfasst als die Einrichtung zur Einleitung des Inertgases einen zweiten Düsenkanal, der unmittelbar in den Reaktionsraum mündet.
c. Der zweite Düsenkanal mündet in einer Mündungsöffnung, die die Mündungsöffnung des ersten Düsenkanals umschließt.

Besonders bevorzugt sind die unmittelbar vorstehenden Merkmale a. bis c. in Kombination miteinander realisiert. Hierdurch kann die thermische Abschirmung der Mündungsöffnung besonders elegant realisiert werden.

Besonders bevorzugt ist die Mündungsöffnung des ersten Düsenkanals rund, insbesondere kreisrund, ausgebildet, während die Mündungsöffnung des zweiten Düsenkanals ringförmig ausgebildet ist. Ein durch diese Öffnung in den Reaktionsraum eingeleitetes Inertgas bildet einen ringförmigen Inertgasstrom, der ein in den Reaktionsraum einströmendes siliziumhaltiges erstes Ausgangsmaterial umschließt.

In einer weiteren bevorzugten Weiterbildung der Erfindung zeichnet sich die Vorrichtung durch das unmittelbar folgende Merkmal a. aus:
a. Die dritte Zuleitung mündet in den Reaktionsraum.

Diese Variante ist insbesondere dann bevorzugt, wenn das erste und das zweite Ausgangsmaterial simultan mit dem hocherhitzten Gas kontaktiert werden. Erfolgt die Zugabe der Ausgangsmaterialien hingegen sequentiell, so kann es durchaus bevorzugt sein, dass die dritte Zuleitung nicht in den Reaktionsraum sondern in einen dem Reaktionsraum nachgeschalteten Raum mündet, der von dem im Reaktionsraum gebildeten siliziumhaltigen Gemisch durchströmt wird.

In bevorzugten Ausführungsformen kann die dritte Zuleitung wie die zweite Zuleitung ausgebildet sein, insbesondere mindestens eines der unmittelbar folgenden Merkmale a. bis c. aufweisen:
a. Die dritte Zuleitung umfasst eine Mehrstoffdüse mit einem ersten Düsenkanal zur Einspeisung des zweiten Ausgangsmaterials.
b. Die Mehrstoffdüse umfasst einen zweiten Düsenkanal, der unmittelbar in den Reaktionsraum mündet.
c. Der zweite Düsenkanal mündet in einer Mündungsöffnung, die die Mündungsöffnung des ersten Düsenkanals umschließt, insbesondere ringförmig umschließt.

Besonders bevorzugt sind die unmittelbar vorstehenden Merkmale a. bis c. in Kombination miteinander realisiert.

In einer weiteren bevorzugten Weiterbildung der Erfindung zeichnet sich die Vorrichtung durch mindestens eines der unmittelbar folgenden Merkmale a. und b. aus:
a. Die Vorrichtung umfasst ein Kühlmittel, mit dem das im Reaktionsraum gebildete Gemisch abgekühlt werden kann.
a. Die dritte Zuleitung mündet in einen Raum, der von dem mit dem Kühlmittel abgekühlten Gemisch durchströmt wird.

Mit Hilfe des Kühlmittels kann ein im Reaktionsraum gebildetes siliziumhaltiges Gemisch abgekühlt werden bevor es in dem mit dem Reaktionsraum verbundenen Raum mit dem zweiten Ausgangsmaterial kontaktiert wird.

Bei dem Kühlmittel kann es sich insbesondere um eine Zuleitung handeln, über die ein Temperiergas in das aus dem Reaktionsraum austretende Gemisch eingespeist werden kann. Besonders geeignet sind Ringdüsen, die von dem abzukühlenden Gemisch durchströmt werden.

Weitere Merkmale, Einzelheiten und Vorzüge der Erfindung ergeben sich aus den Ansprüchen und der Zusammenfassung, deren beider Wortlaut durch Bezugnahme zum Inhalt der Beschreibung gemacht wird, der folgenden Beschreibung bevorzugter Ausführungsformen der Erfindung sowie anhand der Zeichnungen. Hierbei zeigen schematisch:
- Figur 1 eine bevorzugte Ausführungsform einer erfindungsgemäßen Vorrichtung (Geschnittene Darstellung).
- Figur 2 eine bevorzugte Ausführungsform einer erfindungsgemäßen Vorrichtung (Geschnittene Darstellung).
- Figur 3 eine bevorzugte Ausführungsform einer erfindungsgemäßen Vorrichtung (Geschnittene Darstellung).
- Figur 4 eine Mehrstoffdüse zur Einspeisung eines siliziumhaltigen Ausgangsmaterials (Geschnittene Darstellung).

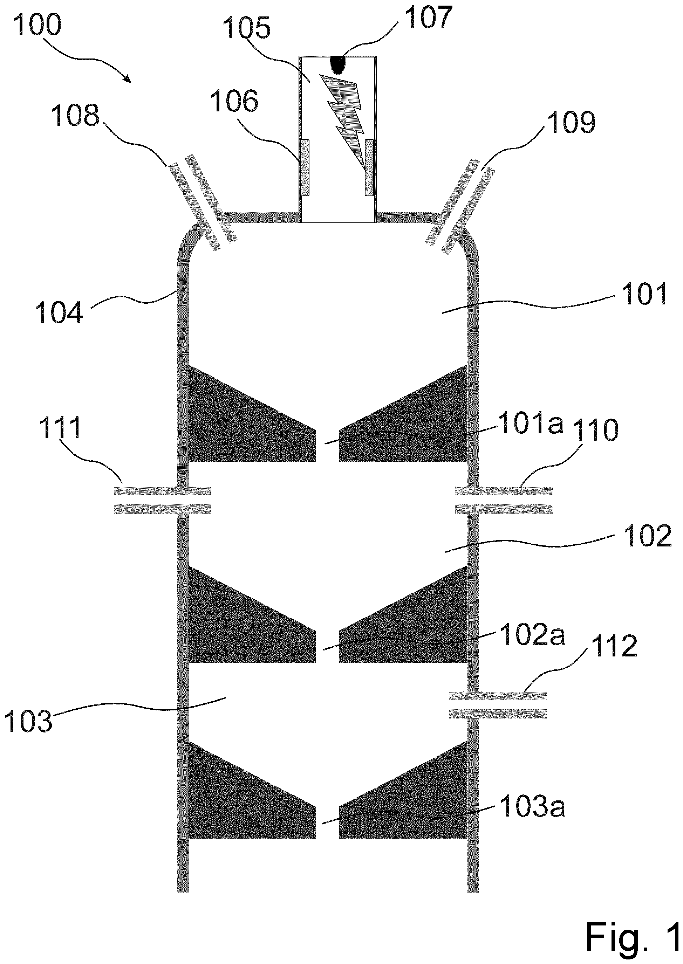

Die in Fig. 1 dargestellte Vorrichtung 100 umfasst drei aufeinanderfolgende Räume 101, 102 und 103, die nach außen von der Wand 104 begrenzt werden und untereinander über die Passagen 101a und 102a verbunden sind.

Bei dem Raum 101 handelt es sich um den Reaktionsraum, in den ein hocherhitztes Gas über die Zuleitung 105 eingespeist wird. In der Zuleitung findet sich eine Einrichtung umfassend die ringförmige Elektrode 106 und die stiftförmige Elektrode 107, zwischen denen durch Anlegen einer elektrischen Spannung ein Lichtbogen erzeugt werden kann. Strömt ein Gas durch die Zuleitung 105, so kann der Lichtbogen einen Energieeintrag in das Gas bewirken, um es in einen hocherhitzten Zustand zu überführen.

Ein mittels des Lichtbogens erhitztes Gas tritt axial in den Reaktionsraum 101 ein, wo es mit einem siliziumhaltigen ersten Ausgangsmaterial kontaktiert werden kann. Dieses kann über die als Mehrstoffdüse ausgebildete Zuleitung 108 in den Reaktionsraum eingespeist werden. Bei Kontaktierung des hocherhitzten Gases und des ersten Ausgangsmaterials bildet sich in dem Reaktionsraum 101 ein Gemisch umfassend das Gas und Silizium.

Ein zweites Ausgangsmaterial, das mit dem Silizium in dem Gemisch eine chemische Reaktion eingehen kann, kann über die Zuleitung 109 in den Reaktionsraum 101 eingespeist werden. Hierbei kann es sich beispielsweise um Ammoniak handeln. Die Zuleitung 109 kann hierbei wie die Zuleitung 108 als Mehrstoffdüse ausgebildet sein.

Die Zuleitung 109 wird insbesondere dann zur Einspeisung des zweiten Ausgangsmaterials in den Reaktionsraum genutzt, wenn siliziumhaltige Materialien gemäß der oben beschriebenen ersten, besonders bevorzugten Variante des erfindungsgemäßen Verfahrens, die sich insbesondere zur Erzeugung von Siliziumcarbid und Siliziumnitrid eignet, erzeugt werden sollen.

Alternativ kann die Zuleitung 109 auch zur Einspeisung von Monosilan Verwendung finden, was sinnvoll sein kann, um den Durchsatz der Vorrichtung zu erhöhen.

Bei den in den Raum 102 eintretenden Zuleitungen 110 und 111 handelt es sich um Zuleitungen zur Einspeisung eines Temperiergases. Dieses kann dazu dienen, ein aus dem Reaktionsraum austretendes Gasgemisch zu kühlen.

Die in den Raum 103 mündende Zuleitung 112 kann zur Einspeisung des zweiten Ausgangsmaterials Anwendung finden. Dies ist insbesondere dann der Fall, wenn siliziumhaltige Materialien gemäß der oben beschriebenen dritten oder vierten besonders bevorzugten Variante des erfindungsgemäßen Verfahrens erzeugt werden sollen.

Erfindungsgemäß erzeugtes siliziumhaltiges Material kann durch die Passage 103a aus der Vorrichtung 100 abgeführt werden.

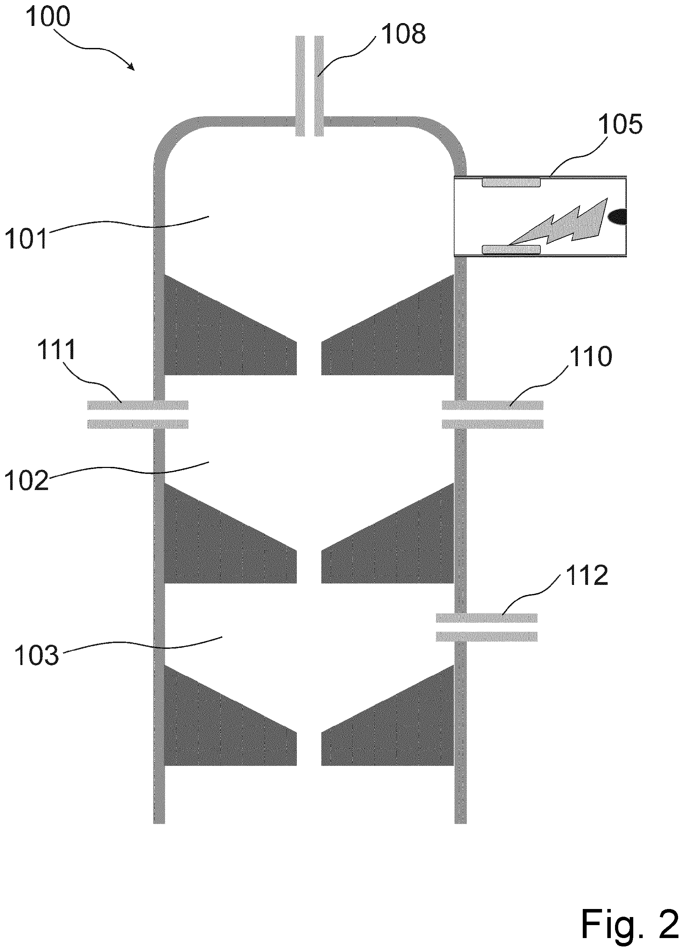

Die in Fig. 2 dargestellte Vorrichtung 101 weicht nur in wenigen Teilaspekten von der Vorrichtung gemäß Fig. 1 ab. So mündet die Zuleitung 105 für das hocherhitzte Gas nicht axial in den Reaktionsraum 101 ein sondern tangential. Darüber hinaus ist nur eine in den Reaktionsraum 101 mündende Zuleitung 108 für das siliziumhaltige erste Ausgangsmaterial vorgesehen.

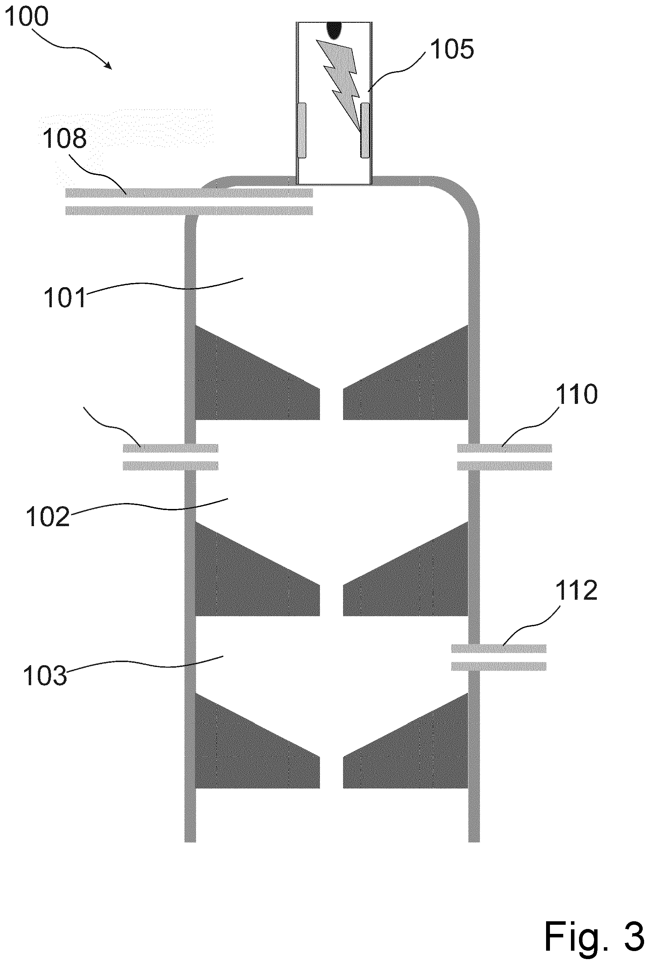

Die in Fig. 3 dargestellte Vorrichtung 100 eignet sich insbesondere zur Erzeugung von mit Kohlenstoff beschichteten Siliziumpartikeln gemäß der oben beschriebenen zweiten, besonders bevorzugten Variante des erfindungsgemäßen Verfahrens. Über die Zuleitung 108 können hier feste Siliziumpartikel in den Reaktionsraum 101 eingespeist und direkt mit über die Zuleitung 105 eintretendem hocherhitzten Gas kontaktiert werden. Das dabei entstehende Gemisch kann im Raum 103 mit einer über die Zuleitung 112 eingespeisten Kohlenstoffquelle wie Methan kontaktiert werden. Zuvor wird das Gemisch im Raum 102 allerdings noch auf eine Temperatur > als die Zersetzungstemperatur der Kohlenstoffquelle und < als die Schmelztemperatur von Silizium gekühlt. Im Raum 103 kann sich die Kohlenstoffquelle an der Oberfläche im Gemisch befindlicher Siliziumpartikel zersetzen und sich dort unter Ausbildung einer Hülle aus Kohlenstoff anlagern.

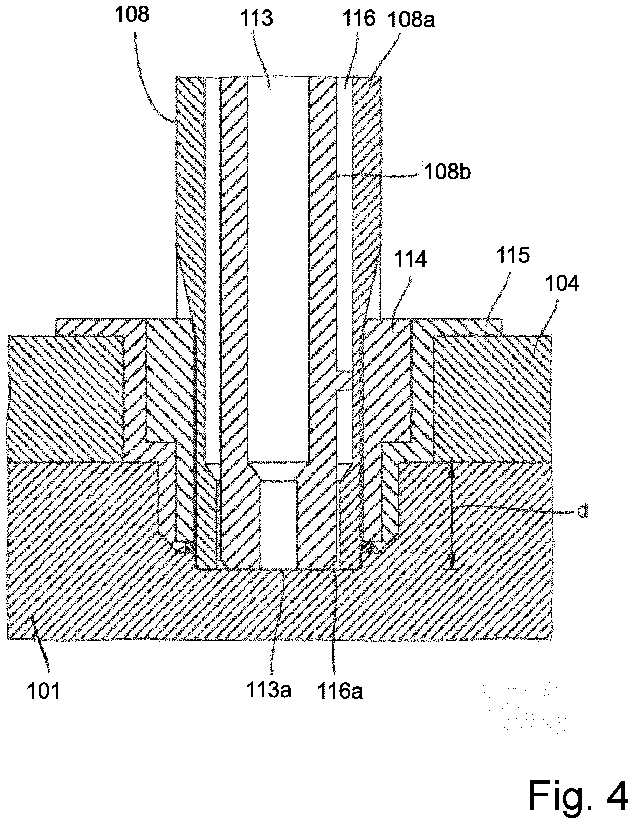

In Fig. 4 ist eine Mehrstoffdüse 108 zur Einspeisung des siliziumhaltigen Ausgangsmaterials, meist Monosilan, dargestellt, wie Sie in den in Fig. 1 und 2 dargestellten Vorrichtungen zum Einsatz kommen kann. Die Düse 108 ist in die Wand 104 der Vorrichtungen 100 integriert, so dass der Düsenkanal 113 der Düse 108, der zur Einspeisung des siliziumhaltigen Ausgangsmaterials dient, unmittelbar in den Reaktionsraum 101 mündet (Mündungsöffnung 113a), und zwar axial und beabstandet von der Wand 104 des Reaktionsraums 101. Von der Wand 104 ist die Düse 108 mittels des ringförmigen Isolierelements 114, das von dem Graphitring 115 umschlossen ist, thermisch isoliert.

Gut zu erkennen ist, dass die Düse 108 in den Reaktionsraum 101 hineinragt, so dass die Mündungsöffnung 113a des Düsenkanals 113 beabstandet von der Wand 104 (Abstand d) in den Reaktionsraum 101 mündet. Dadurch soll die Bildung fester Siliziumablagerungen rund um die Düse 108 vermieden werden.

Neben dem Düsenkanal 113 umfasst die Mehrstoffdüse 108 den zweiten Düsenkanal 116. Auch dieser mündet unmittelbar und axial in den Reaktionsraum 101 (Mündungsöffnung 116a). Begrenzt werden die Düsenkanäle 113 und 116 durch die konzentrisch angeordneten ringförmigen Kanalwände 108a und 108b.

Im Betrieb wird durch die als ringförmiger Spalt ausgebildeten Mündung 116a des Düsenkanals 116 ein Inertgas, meist Wasserstoff, in den Reaktionsraum 101 eingeströmt. Dieses umschließt einen durch den Düsenkanal 113 injizierten Strom des siliziumhaltigen Ausgangsmaterials ringförmig und schirmt die Mündungsöffnung 113a des Düsenkanals 113 vor thermischen Belastungen innerhalb des Reaktionsraums 101 ab.

## Patentansprüche

1. Verfahren zur Erzeugung siliziumhaltiger Materialien mit den Schritten
a. Überführung eines Gases in einen hocherhitzten Zustand, in dem es zumindest teilweise als Plasma vorliegt, und
b. Kontaktieren des hocherhitzten Gases mit einem siliziumhaltigen ersten Ausgangsmaterial unter Bildung eines Gemisches umfassend das Gas sowie Silizium,
wobei zur Erzeugungdersiliziumhaltigen Materialien
c. ein zweites Ausgangsmaterial dem Gas oder dem Gemisch zugesetzt wird,
• welches mit dem Silizium in dem Gemisch unmittelbar eine chemische Reaktion eingehen kann, oder
• welches sich bei Kontakt mit dem hocherhitzten Gas und/oder dem Gemisch thermisch zersetzt,
wobei
d. die Schritte a. und b. räumlich getrennt voneinander erfolgen.

2. Verfahren nach Anspruch 1 mit den folgenden zusätzlichen Schritten:
a. Das Kontaktieren des hocherhitzten Gases mit dem siliziumhaltigen ersten Ausgangsmaterial unter Bildung des Gemisches umfassend das Gas sowie das Silizium erfolgt bei einer Kontaktierungstemperatur, die oberhalb der Zersetzungstemperatur des zu erzeugenden siliziumhaltigen Materials liegt.
b. Das Silizium in dem Gemisch wird mit dem zweiten Ausgangsmaterial bei einer Kontaktierungstemperatur kontaktiert, die oberhalb der Zersetzungstemperatur des zu erzeugenden siliziumhaltigen Materials liegt.
c. Das aus der Kontaktierung des Siliziums und des zweiten Ausgangsmaterials resultierende Gemisch wird zur Erzeugung von Partikeln aus dem siliziumhaltigen Material auf eine Temperatur < der Zersetzungstemperatur des zu erzeugenden siliziumhaltigen Materials abgekühlt.

3. Verfahren nach Anspruch 2 mit mindestens einem der folgenden zusätzlichen Schritte und/oder Merkmale:
a. Das erste Ausgangsmaterial ist Monosilan oder metallisches Silizium in Partikelform, insbesondere Monosilan.
b. Das zweite Ausgangsmaterial ist eine Kohlenstoffquelle, die bei Kontakt mit dem hocherhitzten Gas Kohlenstoff freisetzt.

4. Verfahren nach Anspruch 2 mit mindestens einem der folgenden zusätzlichen Schritte und/oder Merkmale:
a. Das erste Ausgangsmaterial ist Monosilan oder metallisches Silizium in Partikelform, insbesondere Monosilan.
b. Das zweite Ausgangsmaterial ist Stickstoff oder eine Stickstoffquelle, die bei Kontakt mit dem hocherhitzten Gas Stickstoff freisetzt.

5. Verfahren nach Anspruch 1 mit den folgenden zusätzlichen Schritten:
a. Das Kontaktieren des hocherhitzten Gases mit dem siliziumhaltigen ersten Ausgangsmaterial unter Bildung des Gemisches umfassend das Gas sowie das Silizium erfolgt bei einer Kontaktierungstemperatur, die oberhalb der Siedetemperatur von Silizium liegt.
b. Das Gemisch umfassend das Gas sowie das Silizium wird zur Kontaktierung mit dem zweiten Ausgangsmaterial unter Erzeugung von Si-Partikeln auf eine Temperatur < der Schmelztemperatur von Silizium abgekühlt.
c. Die Siliziumpartikel werden mit dem zweiten Ausgangsmaterial bei einer Kontaktierungstemperatur kontaktiert, die > als die Zersetzungstemperatur des zweiten Ausgangsmaterials und < als die Schmelztemperatur von Silizium ist.

6. Verfahren nach Anspruch 5 mit mindestens einem der folgenden zusätzlichen Schritte und/oder Merkmale:
a. Das erste Ausgangsmaterial ist Monosilan oder metallisches Silizium in Partikelform, insbesondere metallisches Silizium in Partikelform.
b. Das zweite Ausgangsmaterial ist eine Kohlenstoffquelle, die bei Kontakt mit den Siliziumpartikeln Kohlenstoff freisetzt.

7. Verfahren nach Anspruch 1 mit den folgenden zusätzlichen Schritten:
a. Das Kontaktieren des hocherhitzten Gases mit dem siliziumhaltigen ersten Ausgangsmaterial unter Bildung des Gemisches umfassend das Gas sowie das Silizium erfolgt bei einer Temperatur, die oberhalb der Schmelztemperatur von Silizium liegt.
b. Das Gemisch umfassend das Gas sowie das Silizium wird zur Kontaktierung mit dem zweiten Ausgangsmaterial unter Erzeugung von Siliziumpartikeln auf eine Temperatur < der Schmelztemperatur von Silizium abgekühlt.
c. Die Siliziumpartikel werden mit dem zweiten Ausgangsmaterial bei einer Temperatur kontaktiert, die > als die Zersetzungstemperatur des zweiten Ausgangsmaterials und < als die Schmelztemperatur von Silizium ist.

8. Verfahren nach Anspruch 7 mit mindestens einem der folgenden zusätzlichen Schritte und/oder Merkmale:
a. Das erste Ausgangsmaterial ist Monosilan.
b. Das zweite Ausgangsmaterial ist eine Kohlenstoffquelle, die bei Kontakt mit den Siliziumpartikeln Kohlenstoff freisetzt.

9. Verfahren nach Anspruch 1 mit den folgenden zusätzlichen Schritten:
a. Das Kontaktieren des hocherhitzten Gases mit dem siliziumhaltigen ersten Ausgangsmaterial unter Bildung des Gemisches umfassend das Gas sowie das Silizium erfolgt bei einer Kontaktierungstemperatur, die oberhalb der Schmelztemperatur von Silizium liegt.
b. Das Silizium in dem Gemisch wird mit dem zweiten Ausgangsmaterial bei einer Kontaktierungstemperatur kontaktiert, die unterhalb der Zersetzungstemperatur des zu erzeugenden siliziumhaltigen Materials liegt, insbesondere bei einer Temperatur < der Zersetzungstemperatur des zu erzeugenden siliziumhaltigen Materials und > der Schmelztemperatur von Silizium.

10. Verfahren nach Anspruch 2 mit mindestens einem derfolgenden zusätzlichen Schritte und/oder Merkmale:
a. Das erste Ausgangsmaterial ist Monosilan oder metallisches Silizium in Partikelform, insbesondere Monosilan.
b. Das zweite Ausgangsmaterial ist eine Kohlenstoffquelle, die bei Kontakt mit dem Gemisch Kohlenstoff freisetzt.

11. Verfahren nach Anspruch 2 mit mindestens einem der folgenden zusätzlichen Schritte und/oder Merkmale:
a. Das erste Ausgangsmaterial ist Monosilan oder metallisches Silizium in Partikelform, insbesondere Monosilan.
b. Das zweite Ausgangsmaterial ist Stickstoff oder eine Stickstoffquelle, die bei Kontakt mit dem Gemisch Stickstoff freisetzt.

12. Vorrichtung (100) zur Erzeugung partikelförmiger Si-haltiger Materialien in einem Verfahren gemäß einem der vorhergehenden Ansprüche mit den Merkmalen
a. Die Vorrichtung (100) umfasst eine Einrichtung (106, 107), mit der ein Gas in einen hocherhitzten Zustand, in dem es zumindest teilweise als Plasma vorliegt, überführt werden kann, und
b. Die Vorrichtung (100) umfasst einen Reaktionsraum (101) und eine darin mündende erste Zuleitung (105) für das hocherhitzte Gas, und
c. Die Vorrichtung (100) umfasst eine zweite Zuleitung (108), die unmittelbar in den Reaktionsraum (101) mündet und durch welche ein siliziumhaltiges erstes Ausgangsmaterial unter Bildung eines Gemisches umfassend das Gas sowie Silizium in den Reaktionsraum (101) eingespeist werden kann, und
d. Die Vorrichtung (100) umfasst eine dritte Zuleitung (112), durch welche ein zweites Ausgangsmaterial,
• welches mit dem Silizium in dem Gemisch unmittelbar eine chemische Reaktion eingehen kann, oder
• welches sich bei Kontakt mit dem hocherhitzten Gas und/oder dem Gemisch thermisch zersetzt,
in die Vorrichtung (100) eingespeist werden kann.

13. Vorrichtung nach Anspruch 12 mit den folgenden zusätzlichen Merkmalen:
a. Die dritte Zuleitung mündet in den Reaktionsraum.

14. Vorrichtung nach Anspruch 12 oder nach Anspruch 13, mit den folgenden zusätzlichen Merkmalen:
a. Die Vorrichtung umfasst ein Kühlmittel (110, 111), mit dem das im Reaktionsraum (101) gebildete Gemisch abgekühlt werden kann.

15. Vorrichtung nach Anspruch 14 mit den folgenden zusätzlichen Merkmalen:
a. Die dritte Zuleitung (112) mündet in einen Raum (103), der von dem mit dem Kühlmittel abgekühlten Gemisch durchströmt wird.

## Claims

1. A process for producing particulate silicon-containing materials, having the steps of
a. converting a gas to a superheated state in which it is at least partly in plasma form, and
b. contacting the superheated gas with a silicon-containing first starting material to form a mixture comprising the gas and silicon,
wherein the silicon-containing materials are produced by
c. adding to the gas or the mixture a second starting material
• which can enter into a chemical reaction directly with the silicon in the mixture, or
• which breaks down thermally on contact with the superheated gas and/or the mixture,
wherein
d. steps a. and b. are effected spatially separately from one another.

2. The process as claimed in claim 1, having the following additional steps:
a. Contacting the superheated gas with the silicon-containing first starting material to form the mixture comprising the gas and the silicon at a contacting temperature above the breakdown temperature of the silicon-containing material to be produced.
b. Contacting the silicon in the mixture with the second starting material at a contacting temperature above the breakdown temperature of the silicon-containing material to be produced.
c. Cooling the mixture resulting from the contacting of the silicon and the second starting material to a temperature less than the breakdown temperature of the silicon-containing material to be produced for production of particles of the silicon-containing material.

3. The process as claimed in claim 2, having at least one of the following additional steps and/or features:
a. The first starting material is monosilane or metallic silicon in particle form, especially monosilane.
b. The second starting material is a carbon source that releases carbon on contact with the superheated gas.

4. The process as claimed in claim 2, having at least one of the following additional steps and/or features:
a. The first starting material is monosilane or metallic silicon in particle form, especially monosilane.
b. The second starting material is nitrogen or a nitrogen source that releases nitrogen on contact with the superheated gas.

5. The process as claimed in claim 1, having the following additional steps:
a. Contacting the superheated gas with the silicon-containing first starting material to form a mixture comprising the gas and the silicon at a contacting temperature above the boiling temperature of silicon.
b. Cooling the mixture comprising the gas and the silicon to a temperature less than the melting temperature of silicon to produce Si particles for contacting with the second starting material.
c. Contacting the silicon particles with the second starting material at a contacting temperature greater than the breakdown temperature of the second starting material and less than the melting temperature of silicon.

6. The process as claimed in claim 5, having at least one of the following additional steps and/or features:
a. The first starting material is monosilane or metallic silicon in particle form, especially metallic silicon in particle form.
b. The second starting material is a carbon source that releases carbon on contact with the silicon particles.

7. The process as claimed in claim 1, having the following additional steps:
a. Contacting the superheated gas with the silicon-containing first starting material to form the mixture comprising the gas and the silicon at a temperature above the melting temperature of silicon.
b. Cooling the mixture comprising the gas and the silicon to a temperature less than the melting temperature of silicon to produce silicon particles for contacting with the second starting material.
c. Contacting the silicon particles with the second starting material at a temperature greater than the breakdown temperature of the second starting material and less than the melting temperature of silicon.

8. The process as claimed in claim 7, having at least one of the following additional steps and/or features:
a. The first starting material is monosilane.
b. The second starting material is a carbon source that releases carbon on contact with the silicon particles.

9. The process as claimed in claim 1, having the following additional steps:
a. Contacting the superheated gas with the silicon-containing first starting material to form the mixture comprising the gas and the silicon at a contacting temperature above the melting temperature of silicon.
b. Contacting the silicon in the mixture with the second starting material at a contacting temperature below the breakdown temperature of the silicon-containing material to be produced, especially at a temperature less than the breakdown temperature of the silicon-containing material to be produced and greater than the melting temperature of silicon.

10. The process as claimed in claim 2, having at least one of the following additional steps and/or features:
a. The first starting material is monosilane or metallic silicon in particle form, especially monosilane.
b. The second starting material is a carbon source that releases carbon on contact with the mixture.

11. The process as claimed in claim 2, having at least one of the following additional steps and/or features:
a. The first starting material is monosilane or metallic silicon in particle form, especially monosilane.
b. The second starting material is nitrogen or a nitrogen source that releases nitrogen on contact with the mixture.

12. An apparatus (100) for producing particulate Si-containing materials in a process as claimed in any of the preceding claims, having the following features:
a. The apparatus (100) comprises a device (106, 107) with which a gas can be converted to a superheated state in which it is at least partly in plasma form, and
b. The apparatus (100) comprises a reaction space (101) and a first feed (105) that opens into it for the superheated gas, and
c. The apparatus (100) comprises a second feed (108) that opens directly into the reaction space (101) and through which a silicon-containing first starting material can be fed into the reaction space (101) to form a mixture comprising the gas and silicon, and
d. The apparatus (100) comprises a third feed (112) through which a second starting material
• which can enter into a chemical reaction directly with the silicon in the mixture, or
• which breaks down thermally on contact with the superheated gas and/or the mixture,
can be fed into the apparatus (100).

13. The apparatus as claimed in claim 12, having the following additional features:
a. The third feed opens into the reaction space.

14. The apparatus as claimed in claim 12 or as claimed in claim 13, having the following additional features:
a. The apparatus comprises a coolant (110, 111) with which the mixture formed in the reaction space (101) can be cooled.

15. The apparatus as claimed in claim 14, having the following additional features:
a. The third feed (112) opens into a space (103) through which the mixture cooled by the coolant flows.

## Revendications

1. Procédé pour la production de matériaux contenant du silicium, présentant les étapes
a. transfert d'un gaz dans un état à haute température, dans lequel il se trouve au moins partiellement sous forme de plasma, et
b. mise en contact du gaz à haute température avec un premier matériau de départ contenant du silicium avec formation d'un mélange comprenant le gaz ainsi que du silicium,
dans lequel, pour la production des matériaux contenant du silicium
c. un deuxième matériau de départ est ajouté au gaz ou au mélange,
- qui peut entrer directement en réaction chimique avec le silicium dans le mélange ou
- qui se décompose thermiquement avec le gaz à haute température et/ou le mélange,
où
d. les étapes a. et b. ont lieu de manière séparée dans l'espace.

2. Procédé selon la revendication 1, présentant les étapes supplémentaires suivantes :
a. la mise en contact du gaz à haute température avec le premier matériau de départ contenant du silicium avec formation du mélange comprenant le gaz ainsi que le silicium a lieu à une température de mise en contact qui est supérieure à la température de décomposition du matériau contenant du silicium à produire,
b. le silicium dans le mélange est mis en contact avec le deuxième matériau de départ à une température de mise en contact qui est supérieure à la température de décomposition du matériau contenant du silicium à produire,
c. le mélange résultant de la mise en contact du silicium et du deuxième matériau de départ est refroidi, pour la production de particules en matériau contenant du silicium, à une température < à la température de décomposition du matériau contenant du silicium à produire.

3. Procédé selon la revendication 2, présentant au moins l'une des étapes et/ou caractéristiques supplémentaires suivantes :
a. le premier matériau de départ est du monosilane ou du silicium métallique sous forme de particules, en particulier du monosilane,
b. le deuxième matériau de départ est une source de carbone qui libère du carbone lors du contact avec le gaz à haute température.

4. Procédé selon la revendication 2, présentant au moins l'une des étapes et/ou caractéristiques supplémentaires suivantes :
a. le premier matériau de départ est du monosilane ou du silicium métallique sous forme de particules, en particulier du monosilane,
b. le deuxième matériau de départ est de l'azote ou une source d'azote qui libère de l'azote lors du contact avec le gaz à haute température.

5. Procédé selon la revendication 1, présentant les étapes supplémentaires suivantes :
a. la mise en contact du gaz à haute température avec le premier matériau de départ contenant du silicium avec formation du mélange comprenant le gaz ainsi que le silicium a lieu à une température de mise en contact qui est supérieure à la température d'ébullition du silicium,
b. le mélange comprenant le gaz ainsi que le silicium est refroidi, pour la mise en contact avec le deuxième matériau de départ avec production de particules de Si, à une température < à la température de fusion du silicium,
c. les particules de silicium sont mises en contact avec le deuxième matériau de départ à une température de mise en contact qui est > à la température de décomposition du deuxième matériau de départ et < à la température de fusion du silicium.

6. Procédé selon la revendication 5, présentant au moins l'une des étapes et/ou caractéristiques supplémentaires suivantes :
a. le premier matériau de départ est du monosilane ou du silicium métallique sous forme de particules, en particulier du silicium métallique sous forme de particules,
b. le deuxième matériau de départ est une source de carbone qui libère du carbone lors du contact avec les particules de silicium.

7. Procédé selon la revendication 1, présentant les étapes supplémentaires suivantes :
a. la mise en contact du gaz à haute température avec le premier matériau de départ contenant du silicium avec formation du mélange comprenant le gaz ainsi que le silicium a lieu à une température qui est supérieure à la température de fusion du silicium,
b. le mélange comprenant le gaz ainsi que le silicium est refroidi, pour la mise en contact avec le deuxième matériau de départ avec production de particules de silicium, à une température < à la température de fusion du silicium,
c. les particules de silicium sont mises en contact avec le deuxième matériau de départ à une température qui est > à la température de décomposition du deuxième matériau de départ et < à la température de fusion du silicium.

8. Procédé selon la revendication 7, présentant au moins l'une des étapes et/ou caractéristiques supplémentaires suivantes :
a. le premier matériau de départ est du monosilane,
b. le deuxième matériau de départ est une source de carbone qui libère du carbone lors du contact avec les particules de silicium.

9. Procédé selon la revendication 1, présentant les étapes supplémentaires suivantes :
a. la mise en contact du gaz à haute température avec le premier matériau de départ contenant du silicium avec formation du mélange comprenant le gaz ainsi que le silicium a lieu à une température de mise en contact qui est supérieure à la température de fusion du silicium,
b. le silicium dans le mélange est mis en contact avec le deuxième matériau de départ à une température de mise en contact qui est inférieure à la température de décomposition du matériau contenant du silicium à produire, en particulier à une température < à la température de décomposition du matériau contenant du silicium à produire et > à la température de fusion du silicium.

10. Procédé selon la revendication 2, présentant au moins l'une des étapes et/ou caractéristiques supplémentaires suivantes :
a. le premier matériau de départ est du monosilane ou du silicium métallique sous forme de particules, en particulier du monosilane,
b. le deuxième matériau de départ est une source de carbone qui libère du carbone lors du contact avec le mélange.

11. Procédé selon la revendication 2, présentant au moins l'une des étapes et/ou caractéristiques supplémentaires suivantes :
a. le premier matériau de départ est du monosilane ou du silicium métallique sous forme de particules, en particulier du monosilane,
b. le deuxième matériau de départ est de l'azote ou une source d'azote qui libère de l'azote lors du contact avec le mélange.

12. Dispositif (100) pour la production de matériaux sous forme de particules, contenant du Si, dans un procédé selon l'une quelconque des revendications précédentes, présentant les caractéristiques
a. le dispositif (100) comprend une installation (106, 107), qui permet de transférer un gaz dans un état à haute température, dans lequel il se trouve au moins partiellement sous forme de plasma, et
b. le dispositif (100) comprend un espace de réaction (101) et une première conduite d'alimentation (105) pour le gaz à haute température qui y débouche et
c. le dispositif (100) comprend une deuxième conduite d'alimentation (108), qui débouche directement dans l'espace de réaction (101) et à travers laquelle un premier matériau de départ contenant du silicium peut être injecté dans l'espace de réaction (101) avec formation d'un mélange comprenant le gaz ainsi que le silicium, et
d. le dispositif (100) comprend une troisième conduite d'alimentation (112), à travers laquelle un deuxième matériau de départ,
- qui peut entrer directement en réaction chimique avec le silicium dans le mélange ou
- qui se décompose thermiquement avec le gaz à haute température et/ou le mélange,
peut être injecté dans le dispositif (100).

13. Dispositif selon la revendication 12, présentant les caractéristiques supplémentaires suivantes :
a. la troisième conduite d'alimentation débouche dans l'espace de réaction.

14. Dispositif selon la revendication 12 ou selon la revendication 13, présentant les caractéristiques supplémentaires suivantes :
a. le dispositif comprend un agent de refroidissement (110,111), qui permet de refroidir le mélange formé dans l'espace de réaction (101).

15. Dispositif selon la revendication 14, présentant les caractéristiques supplémentaires suivantes :
a. la troisième conduite d'alimentation (112) débouche dans un espace (103), à travers lequel s'écoule le mélange refroidi par l'agent de refroidissement.
